# EUROPÄISCHE PATENTSCHRIFT

(11) **EP 4 172 517 B1**
(45) Veröffentlichungstag und Bekanntmachung des Hinweises auf die Patenterteilung: **24.07.2024**
(21) Anmeldenummer: 20736310.2
(22) Anmeldetag: 30.06.2020
(51) Int. Cl.: F16K 11/076, G01B 11/26, G01B 11/27, H01L 21/68, H01L 21/683, H01L 21/67, F16K 11/085, G01B 11/14

(54) **VORRICHTUNG UND VERFAHREN ZUM AUSRICHTEN VON SUBSTRATEN**
DEVICE AND METHOD FOR ALIGNMENT OF SUBSTRATES
DISPOSITIF ET MÉTHODE D'ALIGNEMENT DE SUBSTRATS

(43) Veröffentlichungstag der Anmeldung: 03.05.2023
(73) Patentinhaber: EV Group E. Thallner GmbH, 4782 St. Florian am Inn (AT)
(72) Erfinder: ZINNER, Dominik, 4782 St. Florian am Inn (AT); LINDNER, Friedrich Paul, 4782 St. Florian am Inn (AT); PLACH, Thomas, 4782 St. Florian am Inn (AT); STARZENGRUBER, Peter, 4782 St. Florian am Inn (AT)
(74) Vertreter: Schneider, Sascha
(86) Internationale Anmeldenummer: PCT/EP2020/068407
(87) Internationale Veröffentlichungsnummer: WO 2022/002372

(56) Entgegenhaltungen:
- EP-A1- 2 299 472
- DE-A1- 102005 029 368
- DE-A1- 102012 210 823
- US-A1- 2009 305 176
- US-A1- 2010 139 836
- US-A1- 2018 158 796
- US-A1- 2020 055 729

## Beschreibung

Die Erfindung betrifft eine Vorrichtung und ein Verfahren zum Ausrichten von Substraten.

Im Stand der Technik sind sehr viele Vorrichtungen und Verfahren zum Keilfehlerausgleich bekannt. Ein Keilfehlerausgleich ist beispielsweise in der Lithographie, insbesondere der Photolithographie, von entscheidender Bedeutung da sichergestellt werden muss, dass die Photomaske parallel zur zu belichtenden Substratoberfläche positioniert wird. Jede Schrägstellung zwischen Photomaske und Substrat führt zu einer verzerrten Belichtung der photosensitiven Schicht auf dem Substrat. Ein Keilfehlerausgleich wurde auch bereits für die Verwendung von Prägelithographieanlagen offenbart. So zeigt die WO2012028166A1 eine Vorrichtung und ein Verfahren, bei dem ein Interferometer den Abstand zwischen zwei Substratoberflächen, vermisst. Die Vermessung erfolgt dabei durch eines der beiden transparenten Substrate. Bei den Substraten handelt es sich um Nanoprägestempel. Der Kerngedanke der WO2012028166A1 besteht darin, den Keilfehler zwischen den Substratoberflächen, an denen sich die Prägestrukturen befinden, zu kompensieren. Die WO0210721A2 offenbart hingegen die Keilfehlerkompensation über Oberflächen, die nicht Teil der Funktionaloberfläche sind. Diese Vorgehensweise ist nicht optimal, da nicht davon ausgegangen werden kann, dass die Oberfläche an der die Vermessung stattfindet parallel zur Funktionaloberfläche, im vorliegenden Beispiel die Oberfläche mit den Prägestrukturen, ist. Die Druckschrift US20090101037A1 offenbart eine Vorrichtung und ein Verfahren den Abstand zwischen zwei Oberflächen zu vermessen. Mit der Vermessung an einer einzigen Position kann allerdings kein Keilfehler ausgeglichen werden.

Die Druckschrift US2018/0158796 offenbart eine Bondvorrichtung zum Verbinden von Substraten, umfassend: ein erstes und zweites Halteteil, die ein erstes und ein zweites Substrat durch Vakuum halten; sowie eine Messvorrichtung zur Bestimmung von Positionen und Abständen der Substrate.

In den letzten Jahren wurde der Keilfehlerausgleich zwischen zu bondenden Substraten immer wichtiger, sodass versucht wurde, die Konzepte aus der Lithographie in die Bondtechnologie zu übernehmen.

Ein großes Problem im Stand der Technik besteht darin, dass keine Vorrichtungen oder Verfahren aufgezeigt werden, mit deren Hilfe man den Keilfehlerausgleich mit der notwendigen Geschwindigkeit durchführen kann. Besonders beim Bonden ist der Durchsatz von entscheidender Bedeutung für den wirtschaftlichen Erfolg. Ein weiterer Nachteil besteht darin, dass die meisten Substrate die zum Bonden verwendet werden intransparent für verwendete elektromagnetische Strahlung, insbesondere für sichtbares Licht und Infrarot, sind. Zwar sind Siliziumwafer infrarottransparent, die Infrarottransparenz wird aber durch metallische Beschichtungen, die regelmäßig auf Siliziumwafern aufgebracht werden, wieder zunichte gemacht.

Es ist daher Aufgabe der vorliegenden Erfindung eine Vorrichtung und ein Verfahren zur Ausrichtung von Substraten aufzuzeigen, welche die im Stand der Technik aufgeführten Nachteile zumindest zum Teil beseitigen, insbesondere vollständig beseitigen. Zusätzlich soll eine verbesserte Vorrichtung und ein verbessertes Verfahren zum Ausrichten von Substraten, insbesondere zum Ausgleichen eines Keilfehlers zwischen den Substraten, aufgezeigt werden. Insbesondere soll eine Vorrichtung und ein Verfahren aufgezeigt werden, mit welchen einen Keilfehlerausgleich bei der Bearbeitung von Substraten, insbesondere beim Bonden, schneller und effizienter durchgeführt werden kann. Weiterhin soll eine Vorrichtung und ein Verfahren aufgezeigt werden, mit welchen intransparente, insbesondere für elektromagnetische Strahlung, für sichtbares Licht sowie für Infrarot, Substrate ausgerichtet werden können.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Demnach betrifft die Erfindung eine Vorrichtung zum Ausrichten von Substraten, insbesondere von Wafern, aufweisend:
- einen ersten Substrathalter zur Aufnahme eines ersten Substrates auf einer ersten Substrathalteroberfläche,
- einen zweiten Substrathalter zur Aufnahme eines zweiten Substrates auf einer zweiten Substrathalteroberfläche,
- wobei die erste Substrathalteroberfläche der zweiten Substrathalteroberfläche zugewandt ist, und
- wobei der erste Substrathalter mindestens drei innere Abstandssensoren zur Messung von ersten Abständen zum ersten Substrat aufweist, insbesondere zu einer Substratoberfläche des ersten Substrates, dadurch gekennzeichnet, dass
- der erste Substrathalter mindestens drei äußere Abstandssensoren zur Messung von zweiten Abständen zur zweiten Substrathalteroberfläche des zweiten Substrathalters aufweist.

Weiterhin betrifft die Erfindung ein Verfahren zum Ausrichten von Substraten, insbesondere von Wafern, insbesondere mit der Vorrichtung zum Ausrichten von Substraten, mit den folgenden Schritten, insbesondere mit dem folgenden Ablauf:
i) Aufnehmen eines ersten Substrates auf einer ersten Substrathalteroberfläche eines ersten Substrathalters,
ii) Aufnehmen eines zweiten Substrates auf einer zweiten Substrathalteroberfläche eines zweiten Substrathalters, wobei die erste Substrathalterfläche der zweiten Substrathalterfläche zugewandt ist,
iii) Messen von ersten Abständen zwischen mindestens drei inneren Abstandssensoren des ersten Substrathalters und dem ersten Substrat, insbesondere zu einer Substratoberfläche des ersten Substrates,
iv) Messen von zweiten Abständen zwischen mindestens drei äußeren Abstandssensoren des ersten Substrathalters und der zweiten Substrathalteroberfläche des zweiten Substrathalters.

In einer Ausführungsform der Erfindung ist vorgesehen, dass jeweils einer der mindestens drei inneren Abstandssensoren und jeweils einer der mindestens drei äußeren Abstandssensoren zusammen ein Abstandssensorenpaar bilden, wobei vorzugsweise der innere Abstandssensor und der äußere Abstandssensor eines Abstandssensorenpaares ausgehend von einem Bezugspunkt, insbesondere von einem Mittelpunkt, der ersten Substrathalteroberfläche in radialer Richtung fluchten.

Dabei ist der innere Abstandssensor eines Abstandssensorenpaares so angeordnet, dass dieser einen ersten Abstand zu einem auf der ersten Substrathalteroberfläche angeordnetem ersten Substrat vermessen kann. Der zugehörige äußere Abstandssensor des Abstandssensorenpaares wird nicht durch das erste Substrat verdeckt und kann einen zweiten Abstand zu der gegenüberliegenden Substrathalteroberfläche des zweiten Substrathalters vermessen, wobei vorzugsweise der äußere Abstandssensor in radialer Richtung mit dem inneren Abstandssensor des Abstandssensorenpaares fluchtet. Der äußere Abstandssensor vermisst somit die Substrathalteroberfläche an einem Punkt der vorzugsweise in radialer Richtung mit dem durch den inneren Abstandssensor vermessenen Punkt fluchtet. Dadurch kann, neben konstruktiven Vorteilen, insbesondere die Messgenauigkeit erhöht werden beziehungsweise ein Keilfehler besonders gut bei dem Ausrichten weiterer Substrate ausgeglichen werden.

In einer ganz speziellen erfindungsgemäßen Ausführungsform sind die inneren Abstandssensoren so konzipiert, dass sie den Keilfehler zwischen den Substraten direkt vermessen können, indem sie den Abstand zwischen den beiden zugewandten Substratoberflächen vermessen. Das Messprinzip beruht vorzugsweise auf einer Interferenzmessung. In diesem Fall muss das Substrat, das auf der Seite der Abstandssensoren fixiert ist, transparent für die entsprechende elektromagnetische Strahlung sein.

In einer weiteren Ausführungsform der Erfindung ist vorgesehen, dass der erste Substrathalter mindestens drei Abstandssensorenpaare aufweist, wobei der jeweilige innere Abstandssensor und der jeweilige äußere Abstandssensor der mindestens drei Abstandssensorenpaare vorzugsweise jeweils in radialer Richtung fluchten. Mindestens drei, insbesondere alle Abstandssensorenpaare weisen somit vorzugsweise die in radialer Richtung fluchtenden Abstandssensoren auf. Auf diese Weise kann vorteilhaft die Messgenauigkeit erhöht werden beziehungsweise ein Keilfehler besonders gut bei dem Ausrichten weiterer Substrate ausgeglichen werden.

In einer weiteren Ausführungsform der Erfindung ist vorgesehen, dass die mindestens drei äußeren Abstandssensoren auf einem ersten Kreis um einen Bezugspunkt, insbesondere um einen Mittelpunkt, der ersten Substrathalteroberfläche, insbesondere symmetrisch versetzt, angeordnet sind. Vorzugsweise sind die äußeren Abstandssensoren in einem gleichen Abstand in Umfangsrichtung des ersten Kreises zueinander angeordnet. Durch die, insbesondere symmetrisch versetzte Anordnung der äußeren Abstandssensoren auf dem ersten Kreis, kann vorteilhaft ein Keilfehler an unterschiedlichen Punkten in gleichem Abstand zu dem Bezugspunkt auf der gegenüberliegenden Substrathalteroberfläche erfasst werden und es wird insbesondere die Messgenauigkeit erhöht.

In einer weiteren Ausführungsform der Erfindung ist vorgesehen, dass die mindestens drei inneren Abstandssensoren auf einem zweiten Kreis um einen Bezugspunkt, insbesondere einen Mittelpunkt, der ersten Substrathalteroberfläche, insbesondere symmetrisch versetzt, angeordnet sind, wobei bevorzugt der erste Kreis und der zweite Kreis konzentrisch zueinander sind. Vorzugsweise sind die inneren Abstandssensoren in einem gleichen Abstand in Umfangsrichtung des zweiten Kreises zueinander angeordnet. Durch die, insbesondere symmetrisch, versetzte Anordnung der inneren Abstandssensoren auf dem zweiten Kreis, kann vorteilhaft ein Keilfehler an unterschiedlichen Punkten in gleichem Abstand zu dem Bezugspunkt auf dem ersten Substrat erfasst werden und es wird insbesondere die Messgenauigkeit erhöht. Durch die konzentrische Anordnung haben der erste Kreis und der zweite Kreis einen gemeinsamen Kreismittelpunkt, namentlich den Bezugspunkt. Diese Anordnung ist insbesondere für die Messgenauigkeit des Keilfehlers zwischen den Substraten vorteilhaft. Weiterhin kann insbesondere bei einer Berechnung des Keilfehlerausgleichs vorteilhaft ein gleiches Ortbezugssystem verwendet werden.

In einer weiteren Ausführungsform der Erfindung ist vorgesehen, dass die mindestens drei inneren Abstandssensoren und/oder die mindestens drei äußeren Abstandssensoren unterhalb der ersten Substrathalteroberfläche angeordnet sind. Dadurch kann insbesondere der Konstruktionsaufwand verringert werden und die Vorrichtung vorteilhaft klein konstruiert werden. Neben der Platzersparnis können Sensorkabel und weitere Zuleitungen der Abstandssensoren innerhalb des Substrathalters angeordnet werden. Weiterhin können die inneren Abstandssensoren möglichst nah und mit möglichst geringen Störfaktoren den Abstand zu dem ersten Substrat vermessen. Zudem kann bei in den ersten Substrathalter eingelassenen Abstandssensoren das Substrat vorteilhaft parallel zu der ersten Substrathalteroberfläche bewegt werden ohne an die Abstandssensoren zu stoßen.

In einer weiteren Ausführungsform der Erfindung ist vorgesehen, dass die erste Substrathalteroberfläche und die zweite Substrathalteroberfläche zumindest teilweise, bevorzugt vollständig, übereinander anordbar sind, so dass das erste Substrat auf das zweite Substrat fallen gelassen werden kann. Der erste Substrathalter ist somit vorzugsweise und beispielhaft ein oberer Substrathalter und der zweite Substrathalter ein unterer Substrathalter. Dadurch kann vorteilhaft bei einer Übergabe des ersten Substrates an den zweiten Substrathalter, insbesondere bei einer Kalibrierung, das erste Substrat durch Gravitation auf das zweite Substrat fallen gelassen werden. Dazu ist insbesondere nur das Freigeben durch Fixierelemente notwendig. Somit werden insbesondere keine weiteren Mittel zur Übergabe benötigt.

In einer weiteren Ausführungsform der Erfindung ist vorgesehen, dass die mindestens drei inneren Abstandssensoren und/oder die mindestens drei äußeren Abstandssensoren in radialer Richtung in Bezug auf einen Bezugspunkt, insbesondere einen Mittelpunkt, der ersten Substrathalteroberfläche beweglich sind. Die Abstandssensorenpaare können somit vorteilhaft auf unterschiedlich große Substrate, insbesondere Wafer mit unterschiedlichen Durchmessern, angepasst werden. Eine entsprechende Vorrichtung kann somit vorteilhaft Substrate mit variablen Größen ausrichten.

In einer weiteren Ausführungsform der Erfindung ist vorgesehen, dass die mindestens drei inneren Abstandssensoren entlang des zweiten Kreises und/oder die mindestens drei äußeren Abstandssensoren entlang des ersten Kreises beweglich sind. Somit können die Abstandssensoren vorteilhaft für den jeweiligen Prozess positioniert werden. Beispielsweise könnten bei zusätzlichen Verfahrensschritten andere Bauteile die Messung verhindern oder verschlechtern. Durch die Beweglichkeit entlang des ersten Kreises und des zweiten Kreises kann die Position entsprechend eingestellt werden. Weiterhin ist ein Abgleich an unterschiedlichen Messpunkten entlang des ersten und des zweiten Kreises möglich, so dass die Messgenauigkeit verbessert werden kann.

In einer weiteren Ausführungsform der Erfindung ist vorgesehen, dass die mindestens drei inneren Abstandssensoren und/oder die mindestens drei äußeren Abstandssensoren senkrecht zu der ersten Substrathalteroberfläche beweglich sind. Auf diese Weise kann vorteilhaft die vertikale Position der Abstandssensoren eingestellt werden. Die Abstandssensoren können beispielsweise komplett in den Substrathalter eingelassen werden und ein direktes Anliegen des ersten Substrates an der ersten Substrathalteroberfläche ermöglichen. Weiterhin können die Abstandssensoren für die Wartung vorteilhaft eingestellt werden. Vorteilhaft ist insbesondere auch, dass der Fokus der Abstandssensoren vorteilhaft eingestellt werden kann und somit der Messbereich optimal auf den jeweiligen Prozess sowie an das verwendete Substrat angepasst werden kann.

In einer weiteren Ausführungsform der Erfindung ist vorgesehen, dass der erste Substrathalter und/oder der zweite Substrathalter, insbesondere in Abhängigkeit des ersten Abstände und/oder des zweiten Abstände, zueinander ausrichtbar sind, so dass ein Keilfehler zwischen dem ersten Substrat und dem zweiten Substrat ausgleichbar ist. Die Substrathalter können insbesondere durch Aktuatoren beliebig bewegt werden. Dadurch kann ein von den Abstandssensoren vermessener und von einer elektronischen Datenverarbeitungsvorrichtung berechneter Keilfehler zwischen dem ersten Substrat und dem zweiten Substrat ausgeglichen werden. Dabei ist es insbesondere nicht erforderlich, dass beide Substrathalter ausrichtbar sind. Es kann folglich auch nur einer der Substrathalter ausrichtbar sein. Insbesondere kann der erste Substrathalter und/oder der zweite Substrathalter auch in horizontaler und/oder vertikaler Richtung zu der entsprechenden Substrathalteroberfläche ausrichtbar sein. Auf diese Weise können die auszurichtenden Substrate vorteilhaft aneinander angenähert werden und insbesondere die Messgenauigkeit erhöht werden.

In einer weiteren Ausführungsform der Erfindung ist vorgesehen, dass der erste Substrathalter und/oder der zweite Substrathalter regelbare Fixierelemente aufweist, so dass das erste Substrat und/oder das zweite Substrat fixierbar und/oder freigebbar sind. Somit kann insbesondere bei einer Kalibrierung das erste Substrat auf das zweite Substrat, mittels Freigeben des Substrates durch die Fixierelemente, fallen gelassen werden, wenn der erste Substrathalter oberhalb des zweiten Substrathalters angeordnet ist. Weiterhin kann durch eine Fixierung der Substrate ein Verrutschen der Substrate verhindert werden. Weiterhin kann durch die Fixierelemente sichergestellt werden, dass bei einer Messung durch die Abstandssensoren die jeweiligen Substrate in einer vorgegebenen Position an den entsprechenden Substrathalteroberflächen anliegen. Dadurch kann insbesondere die Messgenauigkeit erhöht werden.

In einer weiteren Ausführungsform der Erfindung ist vorgesehen, dass das Verfahren zusätzlich die folgenden Schritte aufweist, insbesondere mit dem folgenden Ablauf:
a) Speichern der in Schritt iii) gemessenen ersten Abstände der mindestens drei inneren Abstandssensoren (2i), insbesondere in einer elektronischen Datenverarbeitungsvorrichtung,
b) Übergeben des ersten Substrates an den zweiten Substrathalter (1u), so dass das erste Substrat an dem zweiten Substrat anliegt,
c) Messen weiterer erster Abstände zwischen den mindestens drei inneren Abstandssensoren und dem ersten Substrat, wobei das erste Substrat an dem zweiten Substrat anliegt,
d) Ausrichten des ersten Substrathalters und/oder des zweiten Substrathalters, so dass jeweils eine Differenz zwischen den jeweils weiteren gemessenen ersten Abständen der mindestens drei inneren Abstandssensoren und den jeweils gespeicherten ersten Abständen der mindestens drei inneren Abstandssensoren gleich ist, wodurch ein Keilfehler zwischen dem ersten Substrat und dem ersten Substrathalter ausgeglichen wird,
e) Speichern der in Schritt iv) gemessenen zweiten Abstände der mindestens drei äußeren Abstandssensoren zu der zweiten Substrathalteroberfläche des zweiten Substrathalters, insbesondere in der elektronischen Datenverarbeitungsvorrichtung,
wobei das Speichern in Schritt e) nach dem Ausrichten in Schritt d) erfolgt.

Die Messwerte der mindestens drei inneren Abstandssensoren werden gespeichert. Dabei liegt das erste Substrat auf der ersten Substrathalteroberfläche an. Somit wird insbesondere durch diese erste Messung nicht nur der Abstand der Sensoren zu der Substratoberfläche des ersten Substrates bestimmt, sondern auch der Abstand zu der Substrathalteroberfläche des ersten Substrates. Auf diese Weise wird die Vorrichtung auf die Substratoberfläche des ersten Substrates beziehungsweise auf die Substrathalteroberfläche des ersten Substrathalters kalibriert. Anschließend messen die mindestens drei inneren Abstandssensoren erneut jeweils einen Abstand zu dem ersten Substrat, wobei das Substrat auf dem zweiten Substrat anliegt.

Durch Vergleichen dieser zwei Messwerte der entsprechend mindestens drei inneren Abstandssensoren kann ein Keilfehler zwischen den Substraten bestimmt werden und die Ausrichtung des ersten und/oder des zweiten Substrathalters so erfolgen, dass kein Keilfehler zwischen den Substraten mehr vorliegt. Insbesondere unmittelbar nach dem der Keilfehler ausgeglichen wurde, messen die drei äußeren Abstandssensoren den Abstand zu der zweiten Substrathalteroberfläche. Auf diese Weise kann ein Verfahren zum Ausrichten, insbesondere zum Ausgleichen eines Keilfehlers, von Substraten vorteilhaft kalibriert werden, so dass das Verfahren für weitere auszurichtende Substrate nicht erneut kalibriert werden muss. Eine Ausrichtung kann dann vorteilhaft durch die äußeren Abstandssensoren erfolgen. Dadurch wird die Prozessgeschwindigkeit erhöht und es können mehrere Substrate effizient zueinander ausgerichtet werden.

In einer weiteren Ausführungsform der Erfindung ist vorgesehen, dass das Ausrichten eines weiteren ersten Substrates und eines weiteren zweiten Substrates zueinander in Abhängigkeit der zweiten Abstände erfolgt, insbesondere in Abhängigkeit der in Schritt e) gespeicherte zweiten Abstände erfolgt, so dass ein Keilfehler zwischen dem weitern ersten Substrat und dem weiteren zweiten Substrat ausgeglichen wird. Auf diese Weise können vorteilhaft mehrere Substrate der gleichen Art hintereinander ausgerichtet beziehungsweise bearbeitet, insbesondere verbondet, werden. Die Prozessgeschwindigkeit kann somit deutlich erhöht werden und der Ausrichtungsprozess, insbesondere zum Ausgleichen eines Keilfehlers, verbessert werden.

Der Erfindung liegt der Gedanke zu Grunde, an mindestens drei Positionen eines ersten Substrathalters jeweils mindestens zwei Abstandssensoren so zu positionieren, dass mindestens einer der beiden Abstandssensoren die Rückseite eines Substrats am ersten Substrathalter und der jeweils zweite Abstandssensor die Distanz zur Substrathalteroberfläche eines zweiten Substrathalters vermisst. Durch die Verwendung zweier Abstandssensoren pro Position kann der Keilfehlerausgleich für weitere Substratpaare, die zueinander ausgeglichen werden müssen, effizienter, insbesondere schneller, durchgeführt werden.

Der Kern der Erfindung besteht darin eine Vorrichtung und ein Verfahren aufzuzeigen, mit deren Hilfe man in der Lage ist einen Keilfehler zwischen zwei Substraten, insbesondere zwei Wafern, effizienter durchzuführen. Insbesondere kann mit der Erfindung auch der Keilfehler zwischen intransparenten Substraten effizient durchgeführt werden. Die Erfindung beruht insbesondere auf der Verwendung von mindestens sechs Sensoren, von denen jeweils zwei zu jeweils einem Paar vereint, über mindestens drei Positionen eines Substrathalters verteilt sind.

Der Vorteil der Erfindung besteht darin, dass über einen Kalibrierprozess der Keilfehler zwischen den Substraten und gleichzeitig zwischen den Substrathalteroberflächen vermessen wird und in weiteren Prozessschritten der Keilfehler zwischen den Substraten ausgeglichen werden kann, indem man die im Kalibrierprozess vermessenen Abstände zu einer Substrathalteroberfläche erneut einstellt.

Eine Vermessung der, insbesondere intransparenten Substrate, und dem Keilfehler zwischen den Substratoberflächen ist dadurch nicht mehr nötig, sondern wird durch eine nach außen verlegte Abstandsmessung ersetzt. Somit kann auch ein Keilfehler zwischen intransparenten Substraten ausgeglichen werden. Ein weiterer wesentlicher Vorteil besteht also darin, dass der Keilfehler zwischen intransparenten Substrate ausgeglichen werden kann.

Bevorzugt ist, dass die zu verwendenden Substrate alle die gleiche Dickenänderung als Funktion des Ortes besitzen, die im Idealfall natürlich null sein sollte. Die Substrate müssen also nicht gleich dick sein, aber sie sollten möglichst planparallele Oberflächen besitzen. Wenn die Substrate keine planparallelen Oberflächen besitzen, dann sollten sie zumindest alle dieselbe Form und dieselbe Orientierung zur erfindungsgemäßen Anlage besitzen.

Die Erfindung beschreibt eine Vorrichtung und eine Methode um den Keilfehler zwischen zwei Substraten zu beseitigen. Unter einem Substrat ist jede Art von Objekt zu verstehen, das an einem Substrathalter fixiert werden kann. Insbesondere handelt es sich bei einem Substrat um einen Wafer oder um einen Stempel für einen Prägeprozess.

Bereits in der WO2012028166A1 wurden Stempel als Substrate bezeichnet. Diese allgemeine Formulierung wird auch in dieser Druckschrift weiterverfolgt. Im weiteren Verlauf des Textes wird unter einem Substrat hauptsächlich ein Wafer verstanden, da die entsprechenden Zeichnungen einfacher und anschaulicher gestaltet werden können.

Dabei wird die Vorrichtung und das Verfahren vorzugsweise zum Keilfehlerausgleich beim Bonden verwendet.

### Substrathalter

Der Substrathalter verfügt über mindestens drei Positionen. An jeder Position befinden sich mindestens zwei Sensoren. Bei den Sensoren handelt es sich um Abstandssensoren. Jeweils mindestens ein innerer und mindestens ein äußerer Abstandssensor an derselben Position werden im Text auch als Abstandssensorenpaar bezeichnet. Die Abstandssensoren sind vorzugsweise Interferometer. Die Abstandssensoren sind pro Position so positioniert, dass einer der beiden Abstandssensoren die Rückseite eines fixierten Substrats vermessen kann, während der zweite Abstandssensor über das Substrat hinaus vermisst.

Der Abstandssensor, der die Rückseite des fixierten Substrats vermisst wird als erster oder innerer Abstandssensor bezeichnet. Der Abstandssensor, der über das Substrat hinaus vermisst wird als zweiter oder äußerer Abstandssensor bezeichnet. Der zweite Abstandssensor vermisst also die Substratoberfläche des, dem ersten Substrathalter gegenüberliegenden, zweiten Substrathalter.

Dem Fachmann auf dem Gebiet ist klar, dass die erfindungsgemäße Idee weiter verbessert werden könnte, indem man pro Position mehrere innere Abstandssensoren und/oder mehrere äußere Abstandssensoren verwendet. Der Einfachheit halber wird im weiteren Text aber immer nur ein innerer und ein äußerer Abstandssensor pro Position beschrieben werden.

Die Abstandssensorenpaare sind vorzugsweise symmetrisch entlang eines Kreises mit gleichem Winkel positioniert. Werden drei Abstandssensorenpaare verwendet beträgt der Winkel zwischen den Abstandssensorenpaaren vorzugsweise konstant 120°. Denkbar ist aber auch, dass sie nicht winkelgleich positioniert werden. Das ist vor allem dann der Fall, wenn es aus konstruktionstechnischen Gründen nicht machbar ist.

Denkbar ist auch, dass die Abstandssensoren beweglich konstruiert sind. In einer Ausführungsform können sie entlang eines Kreises mit konstantem Radius bewegt werden. In einer bevorzugten Ausführungsform wäre auch eine, insbesondere zusätzlich zum Bewegungsfreiheitsgrad entlang eines Kreise, Radialbewegung denkbar. Im Allgemeinen ist also eine Bewegung der Abstandssensoren mindestens entlang zweier Richtungen denkbar. Die Abstandssensorenpaare könnten dann auf unterschiedliche Substratdurchmesser eingestellt werden und es müsste nur ein entsprechender erfindungsgemäßer Substrathalter konstruiert werden.

Ein wesentlicher Aspekt besteht darin, dass die exakte Positionierung und Fixierung der Abstandssensoren innerhalb des Substrathalters in z-Richtung, d.h. in Dickenrichtung, insbesondere nicht von Relevanz ist. Das liegt daran, dass bei dem Kalibierprozess die inneren Abstandssensoren bei fixiertem Substrat einen Nullpunkt festlegen in Bezug zu dem in weiteren Prozessschritten dann der Abstand zur Rückseite desselben Substrats in einer anderen Position vermessen wird. Auf dieses Merkmal wird in der Verfahrensbeschreibung näher eingegangen werden. Dennoch ist eine bewegliche Ausführungsform der Abstandssensoren in z-Richtung denkbar und umsetzbar. Durch eine Beweglichkeit in z-Richtung können insbesondere die Messbereiche optimaler eingestellt werden. Die Abstandssensoren können sich also in allgemeinster Form entlang dreier unabhängiger Raumrichtungen in Bezug zum Substrathalter bewegen.

In einer anderen Ausführungsform werden zusätzliche Sensoren, insbesondere Infrarotsensoren, zu den äußeren und inneren Abstandssensoren verwendet um eine Erweiterung der WO2012028166A1 mit der erfindungsgemäßen Idee zu erhalten. Es wäre dann möglich, die erfindungsgemäße Idee der Keilfehlerkompensation zusätzlich zu einer in-situ Vermessung des Keilfehlers gemäß der WO2012028166A1 durchzuführen.

Technisch gesehen sieht man am besten 3, vorzugsweise mehr als 3, noch bevorzugter mehr als 5, am bevorzugtesten mehr als 10, am allerbevorzugtesten mehr als 15 Abstandssensorpaare vor. Wirtschaftlich gesehen ist die Anzahl der Abstandssensorpaare allerdings vorzugsweise so gering wie möglich, da die Abstandssensoren relativ teuer sind. Da man mit drei Abstandssensorpaaren die zu erfüllende Aufgabe mathematisch exakt lösen kann, ist die Verwendung von genau drei Abstandssensorpaaren wirtschaftlich bevorzugt und technisch ausreichend.

Die Substrathalter verfügen über Fixierungen. Die Fixierungen dienen dem Festhalten der Substrate. Bei den Fixierungen kann es sich um
1. Mechanische Fixierungen, insbesondere
   1.1. Klemmen
2. Vakuumfixierungen, insbesondere mit
   2.1. einzeln ansteuerbare Vakuumbahnen
   2.2. miteinander verbundenen Vakuumbahnen
3. Elektrische Fixierungen, insbesondere
   3.1. Elektrostatische Fixierungen
4. Magnetische Fixierungen
5. Adhäsive Fixierungen, insbesondere
6. Gel-Pak Fixierungen
7. Fixierungen mit adhäsiven, insbesondere ansteuerbaren, Oberfläche handeln.

Die Fixierungen sind insbesondere elektronisch ansteuerbar. Die Vakuumfixierung ist die bevorzugte Fixierungsart. Die Vakuumfixierung besteht vorzugsweise aus mehreren Vakuumbahnen, die an der Oberfläche des Substrathalters austreten. Die Vakuumbahnen sind vorzugsweise einzeln ansteuerbar. In einer technisch eher realisierbaren Anwendung sind einige Vakuumbahnen zu Vakuumbahnsegmenten vereint, die einzeln ansteuerbar, daher evakuiert oder geflutet werden können. Jedes Vakuumsegment ist allerdings unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig oder kreissegmentförmig konstruiert. Dadurch wird eine gezielte, radialsymmetrische, insbesondere von innen nach außen durchgeführte Fixierung und/oder Loslösung eines Substrats vom Substrathalter ermöglicht.

Erfindungsgemäß werden Substratoberflächen und/oder Substrathalteroberflächen bevorzugt, die über eine möglichst geringe Rauheit verfügen. Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen. Die Rauheit der Substratoberfläche und/oder der Substrathalteroberfläche ist dabei kleiner als 100 µm, vorzugsweise kleiner als 10 µm, noch bevorzugter kleiner als 1 µm, am bevorzugtesten kleiner als 100nm, am allerbevorzugtesten kleiner als 10nm.

Erfindungsgemäß sollte die Welligkeit ebenfalls möglichst gering sein. Unter Welligkeit wird die Gestaltabweichung zweiter Ordnung von der geforderten Oberflächenbeschaffenheit verstanden.

In einer erfindungsgemäßen Ausführungsform sind die Substrathalter so konzipiert, dass sie selbst verformbar sind um durch die Verformung auch das Substrat zu verformen.

### Vorrichtung

Die Vorrichtung besteht aus mindestens einem Substrathalter. Der Substrathalter befindet sich vorzugsweise an der Oberseite der Vorrichtung.

Die Vorrichtung, insbesondere ein unterer Substrathalter, kann über Ladestifte verfügen, um das untere Substrat optimaler ablegen zu können.

Dabei kann die Vorrichtung über Ausrichtungselemente verfügen, um die Substrate in lateraler Richtung, d.h. in x- und y-Richtung zueinander ausrichten zu können. In der einfachsten Ausführungsform handelt es sich dabei um mechanische Ausrichtungselemente wie beispielsweise Stifte an denen die Substrate anschlagen und damit in ihrer lateralen Verschiebung positioniert werden.

Rein mechanische Ausrichtungselemente wie Stifte werden beispielsweise beim Temporärbonden verwendet, bei der eine submikrometergenaue Ausrichtung der Substrate zueinander nicht notwendig ist.

In einer bevorzugteren Ausführungsform handelt es sich um, insbesondere bewegliche, Schieber, mit deren Hilfe ein Substrat lateral verschoben und in Position gebracht werden kann.

In einer anderen Ausführungsform verfügt die Vorrichtung über optische Ausrichtungselemente, mit deren Hilfe charakteristische Merkmale an den Substraten, insbesondere Ausrichtungsmarken detektiert werden können. Die Ausrichtungsmarken werden dann in einem Ausrichtungsprozess durch eine relative Translation zueinander zur Deckung gebracht beziehungsweise zueinander ausgerichtet. Es kann nötig sein, den erfindungsgemäßen Keilfehlerausgleich mit der relativen translatorischen Verschiebung der Substrate zu kombinieren, um die Ausrichtungsmarken korrekt in den Tiefenschärfebereich der Ausrichtungsoptiken zu bekommen. Eine weitere Möglichkeit der Ausrichtung besteht darin, mit Hilfe von Optiken nur die Substratkanten zueinander auszurichten.

Eine optische Ausrichtung ist vor allem dann notwendig, wenn es sich bei den Substraten um Wafer handelt, die im Zuge eines Fusionsbondprozesses miteinander verbondet werden sollen. Des Weiteren ist eine optische Ausrichtung dann von Vorteil, wenn es sich bei mindestens einem der beiden Substrate um einen Prägestempel handelt, der ein Prägemuster in eine Prägemasse auf einem zweiten Substrat prägen soll. In diesem Fall werden vorzugsweise Ausrichtungsmarken verwendet, um eine korrekte Positionierung und Ausrichtung der Substrate zueinander zu gewährleisten.

In einer ganz speziellen erfindungsgemäßen Ausführungsform sind die inneren Abstandssensoren Teil des ersten Substrathalters und die äußeren Abstandssensoren Teil des zweiten Substrathalters.

### Kalibrierverfahren

Zuerst wird ein Kalibrierverfahren beschrieben, dass insbesondere einmal durchgeführt werden muss, um danach den Keilfehler zwischen Substratpaaren korrigieren zu können.

In einem ersten Kalibrierprozessschritt wird ein erstes Substrat auf einen ersten, insbesondere oberen, erfindungsgemäßen Substrathalter geladen und fixiert. Die Fixierung muss dabei so erfolgen, dass alle inneren Abstandssensoren des erfindungsgemäßen Substrathalters den Abstand zur Rückseite des ersten Substrats vermessen können. In diesem Kalibrierprozessschritt wird der Nullpunkt für die Abstandssensoren festgelegt. Unter der Festlegung des Nullpunkts ist zu verstehen, dass die inneren Abstandssensoren bei einer durchgeführten Messung in diesem Prozessschritt einen Messwert von Null erhalten müssen. Da es sich um Abstandssensoren handelt, ist der Messwert gleichzusetzen mit einem Abstandswert. Sollte der Messwert von Null abweichen, muss dieser Messwert von Soft- und/oder Hardware entsprechend gespeichert und bei weiteren Messungen als Offset abgezogen werden. Durch einen Messwert von Null wird angegeben, dass die fixierte Substratoberfläche des oberen fixierten Substrats identisch ist mit der Substrathalteroberfläche, die das Substrat fixiert.

In einem **zweiten** Kalibrierprozessschritt wird ein zweites, unteres Substrat auf einen zweiten Substrathalter geladen. Der zweite Substrathalter muss nicht notwendigerweise wie der erste Substrathalter ausgebildet sein. Der Einfachheit halber wird ein gewöhnlicher Substrathalter ohne die Abstandssensorenpaare beschrieben.

Denkbar wäre natürlich auch, dass zuerst das untere und dann das obere Substrat geladen werden. Die Reihenfolge der ersten beiden Kalibrierprozessschritte ist daher vertauschbar.

In einem **dritten** Kalibrierprozessschritt kann eine relative translatorische Annäherung der Substrathalter zueinander erfolgen. Die Substrathalter sind vor diesem Annäherungsschritt relativ weit voneinander entfernt und werden insbesondere im dritten Schritt zuerst angenähert. Insbesondere kann bereits beim dritten Kalibrierprozessschritt eine, insbesondere grobe Ausrichtung der Substrate zueinander in x- und y-Richtung erfolgen. Da zu diesem Zeitpunkt der Keilfehler noch nicht korrigiert wurde, kann es sich nur um eine grobe Ausrichtung handeln. Der Keilfehlerausgleich würde, im Allgemeinen, eine Feinjustierung natürlich zunichtemachen. Der kleinste Abstand zwischen den sich aneinander zugewandten Substratoberflächen ist dabei kleiner als 5mm, vorzugsweise kleiner als 1mm, noch bevorzugter kleiner als 0.1mm, am bevorzugtesten kleiner als 0.01mm, am allerbevorzugtesten kleiner als 0.001 mm.

In einem **vierten** Kalibrierprozessschritt wird das obere Substrat auf das untere Substrat fallen gelassen bzw. abgelegt.

In einem **fünften** Kalibrierprozessschritt vermessen die inneren Abstandssensoren die Abstände zur Rückseite des fallengelassenen Substrats. Im Allgemeinen sind diese Abstände unterschiedlich.

In einem sechsten Kalibrierprozessschritt kann nun der Keilfehler zwischen der Substratoberfläche des oberen Substrats und der Substrathalteroberfläche des oberen Substrathalters ausgeglichen werden. Dazu werden die Substrathalter zueinander so gekippt, dass die vermessenen Abstände der inneren Abstandssensoren gleich sind. Da eine Nullsetzung der inneren Abstandssensoren im ersten Kalibrierprozessschritt erfolgte, ist gewährleistet, dass die vermessenen Abstände aller Abstandssensoren sich auf die Distanz zwischen der oberen Substrathalteroberfläche und der Rückseite des oberen Substrats beziehen.

In einem **siebten** Kalibrierprozessschritt werden dann die Abstände zu der Substrathalteroberfläche des unteren Substrats mit Hilfe der äußeren Abstandssensoren vermessen. Diese Abstände werden gespeichert und können bei einem weiteren geladenen Substratpaar dazu verwendet werden, den Keilfehler zwischen den beiden Substraten sofort auszugleichen, ohne das obere Substrat erneut fallen lassen zu müssen. Voraussetzung dabei ist natürlich, dass alle geladenen Substrate den gleichen Dickenverlauf, vorzugsweise eine homogene Dicke, besitzen müssen. Sie müssen also nicht dieselbe Dicke besitzen, aber die Dicke muss als Funktion des Ortes konstant sein. Ändert sich die Dicke als Funktion des Ortes, muss auch gewährleistet werden, dass die Substrate, die im weiteren Prozess verwendet werden dieselbe Orientierung zu den Substrathaltern besitzen wie die Substrate, die für den Kalibrierprozess verwendet wurden.

Auf Grund der Gravitation ist es natürlich zweckdienlich, den Substrathalter mit den Abstandssensorenpaaren an der Oberseite zu verwenden und ein oberes, fixiertes Substrat im vierten Kalibrierprozessschritt fallen zu lassen. Dem Fachmann auf dem Gebiet ist aber klar, dass man den Substrathalter mit den Abstandssensorenpaaren auch an der Unterseite vorsehen könnte. Besitzen die Substrate beispielsweise eine dermaßen gute Adhäsion zwischen Ihren Substratoberflächen, wie das bei polierten Siliziumwafern beispielsweise der Fall ist, wäre es auch denkbar, dass der vierte Kalibrierprozessschritt des Fallenlassens ersetzt wird durch ein Hinaufziehen des unteren Substrats an das obere Substrat. Das Hinaufziehen würde durch einen spontanen Prebond erfolgen, sobald die beiden Substrate sich zumindest an einem Punkt berühren und sich eine Bondwelle ausbreitet, die das untere Substrat, das in diesem Fall natürlich nicht vom unteren Substrathalter fixiert werden darf, nach oben zieht.

### Keilfehlerausgleichsverfahren

Nachdem die Kalibrierung durchgeführt wurde kann nun der Keilfehler zwischen zwei Substraten korrigiert werden.

In einem **ersten** Prozessschritt wird ein erstes, oberes Substrat auf einen ersten, oberen, Substrathalter mit den Abstandssensorenpaaren geladen und fixiert.

In einem **zweiten** Prozessschritt wird ein zweites, unteres Substrat auf einen zweiten Substrathalter geladen. Der zweite Substrathalter muss nicht notwendigerweise ein Substrathalter mit Abstandssensorenpaaren sein. Der Einfachheit halber wird ein gewöhnlicher Substrathalter beschrieben.

Denkbar wäre natürlich auch, dass zuerst das untere und dann das obere Substrat geladen werden. Die Reihenfolge der ersten beiden Prozessschritte ist daher vertauschbar.

In einem **dritten** Prozessschritt kann eine relative translatorische Annäherung der Substrathalter zueinander erfolgen. Insbesondere kann bereits beim dritten Prozessschritt eine, vorzugsweise Grob- und/oder Feinausrichtung der Substrate zueinander in x- und y-Richtung erfolgen. Man muss aber bedenken, dass bei einem noch vorhandenen Keilfehler die Feinausrichtung durch die spätere Kompensation des Keilfehlers wieder zunichte gemacht werden kann und in einem späteren Prozessschritt auf alle Fälle nochmals durchgeführt werden muss. Dennoch kann das spätere Ergebnis durch eine Feinausrichtung in diesem Prozessschritt begünstig werden.

In einem **vierten** Prozessschritt werden die gespeicherten Abstände bzw. die mit einer reellen Zahl, einem Faktor x, multiplizierten Abstände zwischen den beiden Substrathaltern an den jeweiligen Positionen der einzelnen äußeren Abstandssensoren eingestellt werden. Dadurch wird automatisch der Keilfehler zwischen den Substraten eliminiert.

Nach dem vierten Prozessschritt ist der Prozess an sich beendet. Es werden nun natürlich noch weitere Prozessschritte folgen. Diese weiteren Prozessschritte sind aber nicht mehr Teil der Idee und werden daher nur oberflächlich erwähnt.

Einige der genannten Prozessschritte des Kalibrier- und/oder Keilfehlerausgleichsverfahren können gleichzeitig ausgeführt werden.

Denkbar ist eine Feinausrichtung der Substrate zueinander. Da der Keilfehler zwischen den Substraten beseitigt wurde, kann eine Feinjustierung die Substrate nun in der Horizontalen Ebene sehr genau zueinander ausrichten. Insbesondere werden die Substrate anhand von Ausrichtungsmarken zueinander ausgerichtet.

Denkbar ist auch eine weitere gleichförmige Annäherung der beiden Substrate um die Substrate noch weiter anzunähern.

Denkbar ist auch eine Durchbiegung des oberen Substrats durch ein zentrisch positioniertes Verkrümmungsmittel, insbesondere einen Stift. Diese Art der Kontaktierung erfolgt insbesondere beim Fusionsbonden.

Denkbar ist auch eine photolithographische Behandlung einer photosensitiven Schicht auf dem unteren Substrat, wenn es sich beim oberen Substrat um eine Photomaske handelt.

Denkbar ist auch ein Prägeschritt einer Prägemasse auf dem unteren Substrat, wenn es sich beim oberen Substrat um einen Stempel, insbesondere einen Weichstempel, handelt.

Der Prozess des Keilfehlerausgleichs ist also nicht auf eine spezielle technische Methode ausgerichtet, sondern kann überall eingesetzt werden, wo es darum geht, zwei Flächen planparallel, d.h. ohne Keilfehler, zueinander auszurichten.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1: eine schematische Aufsicht auf einen ersten erfindungsgemäßen Substrathalter,
- Figur 2: eine schematische Aufsicht auf einen zweiten erfindungsgemäßen Substrathalter,
- Figur 3a: einen ersten Prozessschritt eines Kalibrierprozesses,
- Figur 3b: einen zweiten Prozessschritt eines Kalibrierprozesses,
- Figur 3c: einen dritten Prozessschritt eines Kalibrierprozesses,
- Figur 3d: einen vierten Prozessschritt eines Kalibrierprozesses,
- Figur 3e: einen fünften Prozessschritt eines Kalibrierprozesses,
- Figur 3f: einen sechsten Prozessschritt eines Kalibrierprozesses,
- Figur 3g: einen siebten Prozessschritt eines Kalibrierprozesses,
- Figur 4a: einen ersten Prozessschritt eines Keilfehlerausgleichs,
- Figur 4b: einen zweiten Prozessschritt eines Keilfehlerausgleichs,
- Figur 4c: einen dritten Prozessschritt eines Keilfehlerausgleichs und
- Figur 4d: einen vierten Prozessschritt eines Keilfehlerausgleichs.

In den Figuren sind gleiche Bauteile oder Bauteile mit der gleichen Funktion mit den gleichen Bezugszeichen gekennzeichnet.

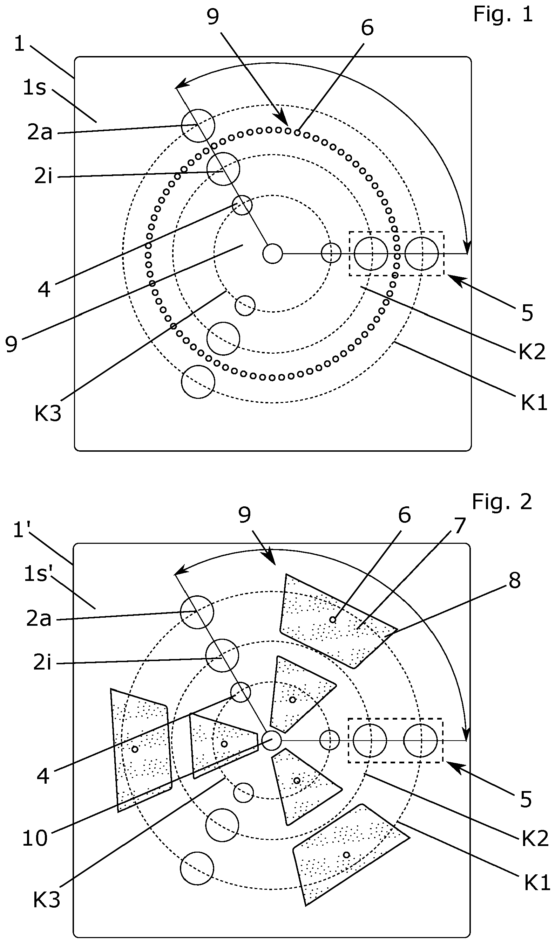

Die **Figur 1** zeigt eine schematische Aufsicht eines Substrathalters 1. Erkennbar ist die Substrathalteroberfläche 1s, auf der ein Substrat 3 (nicht eingezeichnet) fixiert werden kann. Die Fixierung erfolgt über beliebige Fixierelemente 9. Bei den Fixierelementen 9 kann es sich beispielsweise um einfache Vakuumfixierungen, insbesondere Löcher, 6 handeln. Entlang eines ersten Kreises K1 sind drei äußere Abstandssensoren 2a in einem Winkelabstand von 120° erkennbar. Entlang eines zweiten Kreises K2 sind drei innere Abstandssensoren 2i in einem Winkelabstand von 120° erkennbar. Jeweils ein innerer Abstandssensor 2i und ein äußerer Abstandssensor 2a bilden ein Abstandssensorpaar 5. Zusätzlich sind weitere, optionale Sensoren oder Optiken 4, insbesondere entlang eines dritten Kreises K3, erkennbar. Bei den Sensoren oder Optiken 4 kann es sich beispielsweise um Infrarotoptiken handeln, mit deren Hilfe ein Bild der Oberfläche bzw. des Interfaces zwischen zwei Substraten 3o, 3u (nicht eingezeichnet) gemacht werden kann. Die Optiken 4 sind damit nur zusätzliche Sensoren, die nichts mit der eigentlichen erfindungsgemäßen Idee zu tun haben.

Denkbar ist allerdings, dass man mit Hilfe der Sensoren 4 den Keilfehler zwischen zwei Substraten direkt vermessen kann, sofern mindestens das am Substrathalter 1 fixierte Substrat 3 (nicht eingezeichnet) für die Sensoren 4 transparent ist. Das Messprinzip beruht dann vorzugsweise auf einer Interferenzmessung, mit deren Hilfe der Abstand zwischen den beiden Substraten (nicht eingezeichnet) direkt vermessen wird. Dieses Vermessungsprinzip kann auch zusätzlich zum Messprinzip durchgeführt werden.

Die **Figur 2** zeigt eine schematische Aufsicht eines Substrathalters 1 `. Erkennbar ist die Substrathalteroberfläche 1 s', auf der ein Substrat 3 (nicht eingezeichnet) fixiert werden kann. Die Fixierung erfolgt über besondere Fixierelemente 9. Die Fixierelement 9 bestehend aus Vertiefungen 7, die insbesondere durch einen Fräsprozess, in den Substrathalter 1' gefräst worden sind. Die Vertiefungen werden aber nicht vollflächig ausgefräst, sondern weisen in ihrem Inneren Noppen 8 auf, die als Unterstützung für das auf der Substratoberfläche 1s' fixierten Substrat 3 (nicht eingezeichnet) dienen. Innerhalb der Vertiefung 7 existieren dann Vakuumöffnungen 6 über die die Vertiefung 7 evakuiert werden kann.

Insbesondere kann jedes Fixierelement 9 einzeln geschalten werden. Eine derartige Ausführungsform von Fixierelementen 9, die in unterschiedlichen Zonen geschalten und gruppiert werden können sind bereits aus der Druckschrift WO2017162272A1 bekannt. Entlang eines ersten Kreises K1 sind drei äußere Abstandssensoren 2a in einem Winkelabstand von 120° erkennbar. Entlang eines zweiten Kreises K2 sind drei innere Abstandssensoren 2i in einem Winkelabstand von 120° erkennbar. Jeweils ein innerer Abstandssensor 2i und ein äußerer Abstandssensor 2a bilden ein Abstandssensorpaar 5. Zusätzlich sind weitere, optionale Sensoren oder Optiken 4, insbesondere entlang eines dritten Kreises K3, erkennbar. Bei den Sensoren oder Optiken 4 kann es sich beispielsweise um Infrarotoptiken handeln, mit deren Hilfe ein Bild der Oberfläche bzw. des Interfaces zwischen zwei Substraten 3o, 3u (nicht eingezeichnet) gemacht werden kann.

Dem Fachmann auf dem Gebiet ist klar, dass die Art der Fixierelemente 9 die Idee nicht beeinflusst und dass der Fachmann aus einer Vielzahl von Fixierelementen beliebig wählen kann.

Die Substrathalter 1, 1' verfügen insbesondere in der Mitte über ein Verformelement 10. Bei dem Verformelement 10 handelt es sich insbesondere um einen Durchgang, insbesondere eine Bohrung, durch welche ein Stift (nicht eingezeichnet) einen fixierten Wafer krümmen kann. Das Verformelement 10 kann auch als Düse oder Durchgang konzipiert werden, durch die ein Fluid an die Rückseite eines Substrats (nicht eingezeichnet) gelangt und dieses durch eine Druckerhöhung verformen. Die Krümmung des Substrats 3 (nicht eingezeichnet) ist allerdings kein essentieller Bestandteil der Erfindung und wird hier nicht näher erläutert.

Die nachfolgenden Figurenbeschreibungen stellen das Kalibrierverfahren und das Keilfehlerausgleichsverfahren durch schematische Darstellungen im Querschnitt dar. Jede Figur besteht aus zwei Darstellungen.

Die linke Darstellung einer jeden Figur zeigt eine auf das absolute Minimum reduzierte volle Seitenansicht von Substrathaltern 1u, 1o und Substraten 3u, 3o. Die Substrate 3u, 3o und Substrathalter 1u, 1o wurden absichtlich ungleichförmig und stark verkippt dargestellt, um das Verfahren leichter nachvollziehen zu können. Dem Fachmann auf dem Gebiet ist klar, dass insbesondere die Substrathalteroberflächen der Vorder- und Rückseite zueinander mit extrem geringen Toleranzen planparallel gefertigt werden. Dasselbe gilt für die Substratoberflächen. Dem Fachmann ist auch klar, dass die Rotationsabweichungen zwischen den Substrathaltern 1u, 1o bzw. den Substraten 3u, 3o nur einige wenige, wenn nicht sogar einige wenige zehntel, Grad beträgt.

Die rechte Darstellung einer jeden Figur zeigt eine reduzierte, auf ein einzelnes Ausrichtungspaar 5 bezogene Querschnittsseitenansicht von Substrathaltern 1u, 1o und Substraten 3u, 3o. Im Gegensatz zu der linken Darstellung sind die Vorder- und Rückseite der Substrathalter 1u, 1o zueinander planparallel ausgeführt. Dasselbe gilt für die Substrate 3u, 3o. Des Weiteren sind die Rotationsabweichungen zwischen den Substrathaltern 1u, 1o bzw. den Substraten 3u, 3o um ein Vielfaches geringer als dargestellt.

Die rechte Darstellung einer Figur wird für die Anschaulichkeit eines Prozessschrittes herangezogen. Die linke Darstellung einer jeden Figur erlaubt eine schnelle Erfassung der Orientierungssituation einzelner Oberflächen.

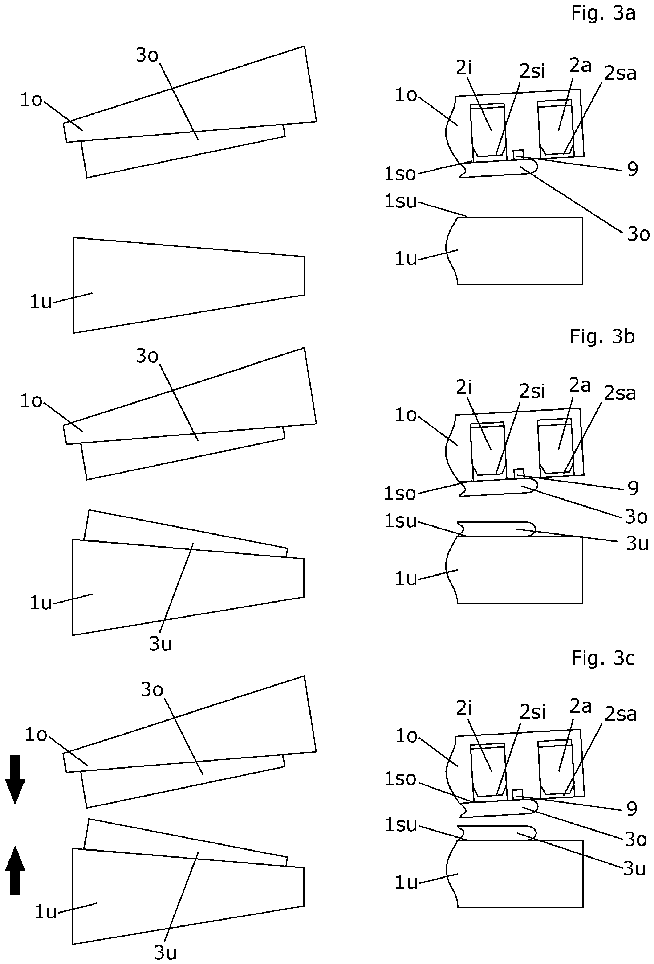

Die **Figur 3a** zeigt einen Ausschnitt einer Vorrichtung in einem ersten Kalibrierprozessschritt, bei dem ein oberes Substrat 3o auf den erfindungsgemäßen, oberen Substrathalter 1o geladen und fixiert wird. In diesem Kalibrierprozessschritt erfolgt insbesondere die Einstellung des Nullpunkts für die inneren Abstandssensoren 2i.

Die **Figur 3b** zeigt einen Ausschnitt einer Vorrichtung in einem **zweiten** Kalibrierprozessschritt, bei dem ein unteres Substrat 3u auf den unteren Substrathalter lo geladen und fixiert wird.

Die **Figur 3c** zeigt einen Ausschnitt einer Vorrichtung in einem **dritten** Kalibrierprozessschritt, bei dem eine Annäherung der beiden Substrate 3u und 3o erfolgt, indem sich die Substrathalter 1o, 1u relativ zueinander bewegen. In diesem Prozessschritt kann es auch bereits zu einer, insbesondere groben, Ausrichtung der beiden Substrate 3u und 3o in lateraler Richtung kommen.

In allen Figuren ist erkennbar, dass die Abstandssensoroberflächen 2si, 2sa nicht innerhalb derselben Ebene liegen. Erfindungsgemäß ist das auch nicht von Relevanz, da der Nullpunkt des inneren Abstandssensor 2i zu einem Zeitpunkt festgelegt wird, an dem das obere Substrat 3o noch am oberen Substrathalter 1o fixiert wird. Insbesondere erfolgt die Festlegung des Nullpunkts bereits im ersten erfindungsgemäßen Kalibrierprozessschritt, spätestens aber zu einem Zeitpunkt vor dem Loslassen des oberen Substrats. Es wäre auch denkbar, dass die Abstandssensoroberflächen 2si, 2sa innerhalb derselben Ebene liegen, allerdings wird man die Abstandssensoren 2a, 2i nie so exakt positionieren können.

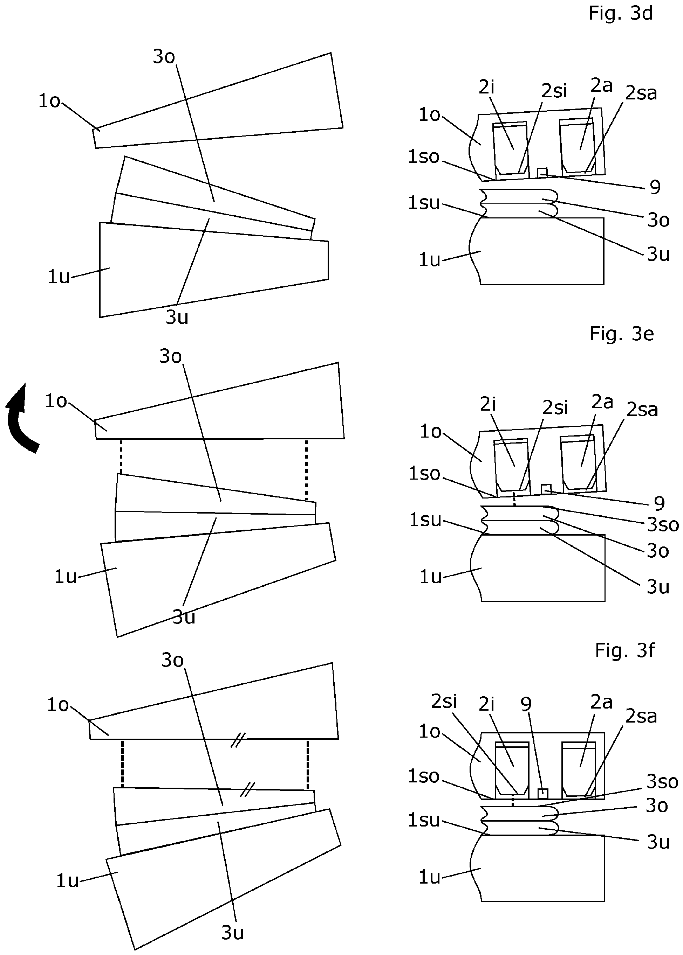

Die **Figur 3d** zeigt einen Ausschnitt einer Vorrichtung in einem **vierten** Kalibrierprozessschritt, bei dem das obere Substrat 3o auf dem unteren Substrat 3u abgelegt bzw. vorzugsweise auf das untere Substrat 3u fallengelassen wird.

Die **Figur 3e** zeigt einen Ausschnitt einer Vorrichtung in einem **fünften** Kalibrierprozessschritt bei dem die inneren Abstandssensoren 2i die Distanz zur Substratoberfläche 3so des oberen Substrats 3o vermessen. Ein wesentlicher Aspekt besteht darin, dass die von den inneren Abstandssensoren 2i vermessenen Abstände nicht die Distanz zwischen der inneren Abstandssensoroberfläche 2si und der Substratoberfläche 3so sondern die Distanz zwischen der Substrathalteroberfläche 1so und der Substratoberfläche 3so darstellen. Dieser Schritt ist ausschließlich Teil der Kalibrierung und wird beim Keilfehlerausgleich zwischen weiteren Substratpaaren nicht mehr durchgeführt.

Die **Figur 3f** zeigt einen Ausschnitt einer Vorrichtung in einem sechsten Kalibrierprozessschritt, bei dem der Keilfehler zwischen der oberen Substrathalterfläche 1so und der Substratoberfläche 3so des oberen Substrats 3o mit Hilfe der Abstandsvermessung der inneren Abstandssensoren 2i ausgeglichen wird. Dieser Schritt ist ausschließlich Teil der Kalibrierung und wird beim Keilfehlerausgleich zwischen weiteren Substratpaaren nicht mehr durchgeführt.

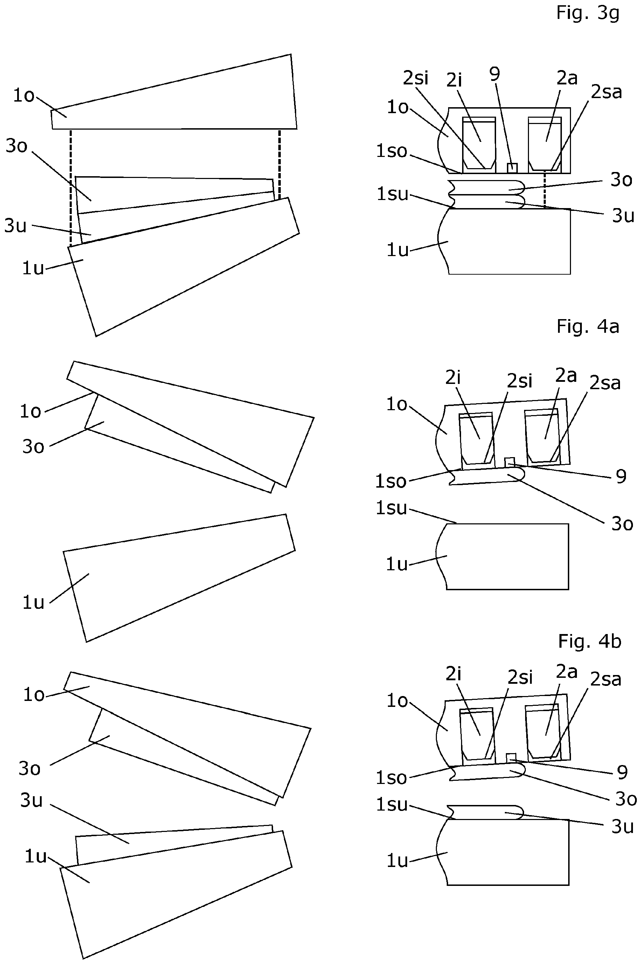

Die **Figur 3g** zeigt einen Ausschnitt einer Vorrichtung in einem **siebten** Kalibrierprozessschritt, indem die äußeren Abstandssensoren 2a die Abstände zur Substrathalteroberfläche 1su des unteren Substrathalters 1u vermessen. Diese Abstände werden nun gespeichert.

Der dargestellte Prozess in den Figuren 1a bis 1g stellt einen Kalibrierprozess dar. Die durch den Kalibrierprozess erhaltenen Abstände der äußeren Abstandssensoren 2a können nun verwendet werden, um den Keilfehler zwischen weiteren Substratpaaren zu kompensieren.

Die **Figur 4a** zeigt einen Ausschnitt einer Vorrichtung in einem **ersten** Prozessschritt, bei dem ein oberes Substrat 3o auf den erfindungsgemäßen, oberen Substrathalter 1o geladen und fixiert wird.

Die **Figur 4b** zeigt einen Ausschnitt einer Vorrichtung in einem **zweiten** Prozessschritt, bei dem ein unteres Substrat 3u auf den unteren Substrathalter 1o geladen und fixiert wird.

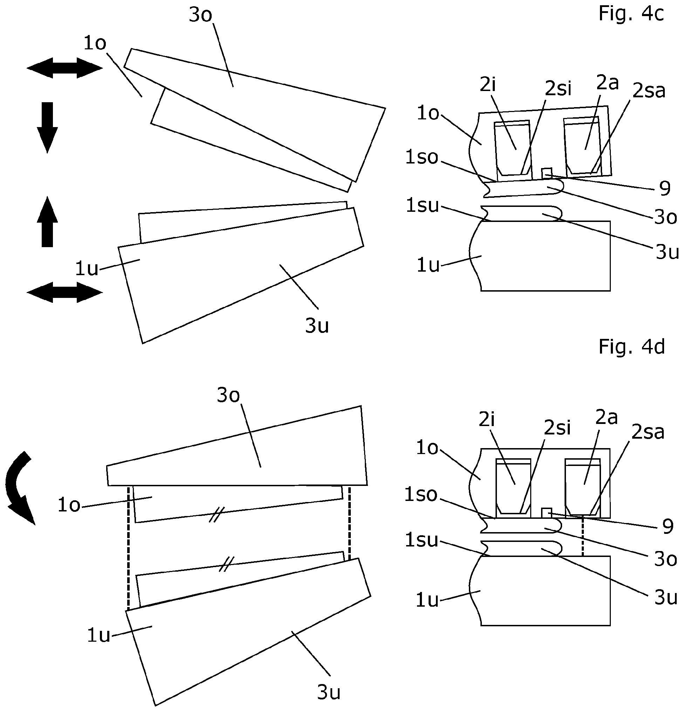

Die **Figur 4c** zeigt einen Ausschnitt einer Vorrichtung in einem **dritten** Prozessschritt bei dem eine Annäherung der beiden Substrate 3u und 3o erfolgt, indem sich die Substrathalter 1o, 1u relativ zueinander bewegen. In diesem Prozessschritt kann es auch bereits zu einer, insbesondere groben, Ausrichtung der beiden Substrate 3u und 3o in lateraler Richtung kommen.

Die **Figur 4d** zeigt einen Ausschnitt einer Vorrichtung in einem **vierten** Prozessschritt bei dem die beiden Substrathalter 1u, 1o solange zueinander angepasst werden, bis die im Kalibrierprozessschritt sieben gespeicherten Abstände der äußeren Abstandssensoren bzw. die mit einer reellen Zahl, einem Faktor x, multiplizierten Abstände, erreicht wurden. In diesem Zustand wurde dann der Keilfehler zwischen den Substraten 3u, 3o kompensiert.

Der Schutzbereich des europäischen Patents wird durch die Patentansprüche bestimmt.

### Bezugszeichenliste

- 1, 1o, 1u, 1': Substrathalter
- 1s, 1so, 1su, 1s': Substrathalteroberfläche
- 2i, 2a: Abstandssensor
- 2si, 2sa: Abstandssensoroberfläche
- 3, 3o, 3u: Substrat
- 3so: Substratoberfläche
- 4: Sensoren oder Optiken
- 5: Abstandssensorpaar
- 6: Vakuumöffnung
- 7: Vertiefungen
- 8: Noppen
- 9: Fixierelement
- 10: Durchgang
- K1, K2, K3: Kreis

## Patentansprüche

1. Vorrichtung zum Ausrichten von Substraten, insbesondere von Wafern, aufweisend:
- einen ersten Substrathalter (1, 1', 1o) zur Aufnahme eines ersten Substrates (3, 3o) auf einer ersten Substrathalteroberfläche (1s, ls`, 1so),
- einen zweiten Substrathalter (1u) zur Aufnahme eines zweiten Substrates (3u) auf einer zweiten Substrathalteroberfläche (1su),
- wobei die erste Substrathalteroberfläche (1s, 1s', 1so) der zweiten Substrathalteroberfläche (1su) zugewandt ist,
- wobei der erste Substrathalter (1, 1', 1o) mindestens drei innere Abstandssensoren (2i) zur Messung von ersten Abständen zum ersten Substrat (3, 3o), insbesondere zu einer Substratoberfläche (3so) des ersten Substrates (3, 3o), aufweist, und
- der erste Substrathalter (1, 1', 1o) mindestens drei äußere Abstandssensoren (2a) zur Messung von zweiten Abständen zur zweiten Substrathalteroberfläche (1su) des zweiten Substrathalters (1u) aufweist.

2. Vorrichtung nach Anspruch 1, wobei jeweils einer der mindestens drei inneren Abstandssensoren (2i) und jeweils einer der mindestens drei äußeren Abstandssensoren (2a) zusammen ein Abstandssensorenpaar (5) bilden, wobei vorzugsweise der jeweilige innere Abstandssensor (2i) und der jeweilige äußere Abstandssensor (2a) des Abstandssensorenpaares (5) ausgehend von einem Bezugspunkt, insbesondere von einem Mittelpunkt, der ersten Substrathalteroberfläche (1s, 1s', 1so) in radialer Richtung fluchten.

3. Vorrichtung nach wenigstens einem der vorhergehenden Ansprüche, wobei der erste Substrathalter (1, 1', 1o) mindestens drei Abstandssensorenpaare (5) aufweist, wobei der jeweilige innere Abstandssensor (2i) und der jeweilige äußere Abstandssensor (2a) der mindestens drei Abstandssensorenpaare (5) jeweils in radialer Richtung fluchten.

4. Vorrichtung nach wenigstens einem der vorhergehenden Ansprüche, wobei die mindestens drei äußeren Abstandssensoren (2a) auf einem ersten Kreis (K1) um einen Bezugspunkt, insbesondere um einen Mittelpunkt, der ersten Substrathalteroberfläche (1s, 1s', 1so), insbesondere symmetrisch versetzt, angeordnet sind.

5. Vorrichtung nach wenigstens einem der vorhergehenden Ansprüche, wobei die mindestens drei inneren Abstandssensoren (2i) auf einem zweiten Kreis (K2) um einen Bezugspunkt, insbesondere um einen Mittelpunkt, der ersten Substrathalteroberfläche (1s, 1s', 1so), insbesondere symmetrisch versetzt, angeordnet sind, wobei bevorzugt der erste Kreis (K1) und der zweite Kreis (K2) konzentrisch zueinander sind.

6. Vorrichtung nach wenigstens einem der vorhergehenden Ansprüche, wobei die mindestens drei inneren Abstandssensoren (2i) und/oder die mindestens drei äußeren Abstandssensoren (2a) unterhalb der ersten Substrathalteroberfläche (1s, 1s', 1so) angeordnet sind.

7. Vorrichtung nach wenigstens einem der vorhergehenden Ansprüche, wobei die erste Substrathalteroberfläche (1s, 1s', 1so) und die zweite Substrathalteroberfläche (1su) zumindest teilweise, bevorzugt vollständig, übereinander anordbar sind, so dass das erste Substrat (3, 3o) auf das zweite Substrat (3u) fallen gelassen werden kann.

8. Vorrichtung nach wenigstens einem der vorhergehenden Ansprüche, wobei die mindestens drei inneren Abstandssensoren (2i) und/oder die mindestens drei äußeren Abstandssensoren (2a) in radialer Richtung in Bezug auf einen Bezugspunkt, insbesondre einen Mittelpunkt, der ersten Substrathalteroberfläche (1s, 1 s', 1so) beweglich sind.

9. Vorrichtung nach wenigstens einem der vorhergehenden Ansprüche, wobei die mindestens drei inneren Abstandssensoren (2i) entlang des zweiten Kreises (K2) und/oder die mindestens drei äußeren Abstandssensoren (2a) entlang des ersten Kreises (K1) beweglich sind.

10. Vorrichtung nach wenigstens einem der vorhergehenden Ansprüche, wobei die mindestens drei inneren Abstandssensoren (2i) und/oder die mindestens drei äußeren Abstandssensoren (2a) senkrecht zu der ersten Substrathalteroberfläche (1s, 1s', 1so) beweglich sind.

11. Vorrichtung nach wenigstens einem der vorhergehenden Ansprüche, wobei der erste Substrathalter (1, 1', 1o) und/oder der zweite Substrathalter (1u), insbesondere in Abhängigkeit der ersten Abstände und/oder der zweiten Abstände, zueinander ausrichtbar sind, so dass insbesondere ein Keilfehler zwischen dem ersten Substrat (3, 3o) und dem zweiten Substrat (3u) ausgleichbar ist.

12. Vorrichtung nach wenigstens einem der vorhergehenden Ansprüche, wobei der erste Substrathalter (1, 1', 1o) und/oder der zweite Substrathalter (1u) regelbare Fixierelemente (9) aufweist, so dass das erste Substrat (3, 3o) und/oder das zweite Substrat (3u) fixierbar und/oder freigebbar sind.

13. Verfahren zum Ausrichten von Substraten, insbesondere von Wafern, insbesondere mit einer Vorrichtung nach wenigstens einem der vorhergehenden Ansprüche, mit den folgenden Schritten, insbesondere mit dem folgenden Ablauf:
i) Aufnehmen eines ersten Substrates (3, 3o) auf einer ersten Substrathalteroberfläche (1s, 1s', 1so) eines ersten Substrathalters (1, 1', 1o),
ii) Aufnehmen eines zweiten Substrates (3u) auf einer zweiten Substrathalteroberfläche (1su) eines zweiten Substrathalters (1u), wobei die erste Substrathalterfläche (1s, 1s', 1so) der zweiten Substrathalterfläche (1su) zugewandt ist,
iii) Messen von ersten Abständen zwischen mindestens drei inneren Abstandssensoren (2i) des ersten Substrathalters (1, 1', 1o) und dem ersten Substrat (3, 3o), insbesondere einer Substratoberfläche (3so) des ersten Substrates (3, 3o),
iv) Messen von zweiten Abständen zwischen mindestens drei äußeren Abstandssensoren (2a) des ersten Substrathalters (1, 1', 1o) und der zweiten Substrathalteroberfläche (1su) des zweiten Substrathalters (1u).

14. Verfahren nach Anspruch 13, wobei das Verfahren zusätzlich die folgenden Schritte aufweist, insbesondere mit dem folgenden Ablauf:
a) Speichern der in Schritt iii) nach Anspruch 13 gemessenen ersten Abstände der mindestens drei inneren Abstandssensoren (2i), insbesondere in einer elektronischen Datenverarbeitungsvorrichtung,
b) Übergeben des ersten Substrates (3, 3o) an den zweiten Substrathalter (1u), so dass das erste Substrat (3, 3o) an dem zweiten Substrat (3u) anliegt,
c) Messen weiterer erster Abstände zwischen den mindestens drei inneren Abstandssensoren (2i) und dem ersten Substrat (3, 3o), wobei das erste Substrat (3, 3o) an dem zweiten Substrat (3u) anliegt,
d) Ausrichten des ersten Substrathalters (1, 1', 1o) und/oder des zweiten Substrathalters (1u), so dass jeweils eine Differenz zwischen den jeweils weiteren gemessenen ersten Abständen der mindestens drei inneren Abstandssensoren (2i) und den jeweils gespeicherten ersten Abständen der mindestens drei inneren Abstandssensoren (2i) gleich ist, wodurch ein Keilfehler zwischen dem ersten Substrat (3, 3o) und dem ersten Substrathalter (1,1',1o) ausgeglichen wird,
e) Speichern der in Schritt iv) nach Anspruch 13 gemessenen zweiten Abstände der mindestens drei äußeren Abstandssensoren (2a) zu der zweiten Substrathalteroberfläche (1su) des zweiten Substrathalters (1u), insbesondere in der elektronischen Datenverarbeitungsvorrichtung,
wobei das Speichern in Schritt e) nach dem Ausrichten in Schritt d) erfolgt.

15. Verfahren nach wenigstens einem der vorhergehenden Ansprüche, wobei das Ausrichten eines weiteren ersten Substrates (3, 3o) und eines weiteren zweiten Substrates (3u) zueinander in Abhängigkeit der zweiten Abstände erfolgt, insbesondere in Abhängigkeit der in Schritt e) nach Anspruch 14 gespeicherten zweiten Abstände erfolgt, so dass ein Keilfehler zwischen dem weitern ersten Substrat (3, 3o) und dem weiteren zweiten Substrat (3u) ausgeglichen wird.

## Claims

1. A device for the alignment of substrates, in particular wafers, comprising:
- a first substrate holder (1, 1', 1o) for mounting a first substrate (3, 3o) on a first substrate holder surface (1s, 1s', 1so),
- a second substrate holder (1u) for mounting a second substrate (3u) on a second substrate holder surface (1su),
- wherein the first substrate holder surface (1s, 1s', 1so) is facing towards the second substrate holder surface (1su),
- wherein the first substrate holder (1, 1', 1o) comprises at least three inner distance sensors (2i) for the measurement of first distances to the first substrate (3, 3o), in particular to a substrate surface (3so) of the first substrate (3, 3o), and
- the first substrate holder (1, 1', 1o) comprises at least three outer distance sensors (2a) for the measurement of second distances to the second substrate holder surface (1su) of the second substrate holder (1u).

2. The device according to claim 1, wherein one each of the at least three inner distance sensors (2i) and one each of the least three outer distance sensors (2a) together form a distance sensor pair (5), wherein the respective inner distance sensor (2i) and the respective outer distance sensor (2a) of the distance sensor pair (5) are preferably aligned in the radial direction proceeding from a reference point, in particular from a centre-point, of the first substrate holder surface (1s, 1s', 1so).

3. The device according to at least one of the preceding claims, wherein the first substrate holder (1, 1', 1o) comprises at least three distance sensor pairs (5), wherein the respective inner distance sensor (2i) and the respective outer distance sensor (2a) of the at least three distance sensor pairs (5) are each aligned in the radial direction.

4. The device according to at least one of the preceding claims, wherein the at least three outer distance sensors (2a) are arranged on a circle (K1), in particular symmetrically offset, around a reference point, in particular around a centre-point of the first substrate holder surface (1s, 1s', 1so).

5. The device according to at least one of the preceding claims, wherein the at least three inner distance sensors (2i) are arranged on a second circle (K2), in particular symmetrically offset, around a reference point, in particular around a centre-point, of the first substrate holder surface (1s, 1s', 1so), wherein the first circle (K1) and the second circle (K2) are concentric with one another.

6. The device according to at least one of the preceding claims, wherein the at least three inner distance sensors (2i) and/or the at least three outer distance sensors (2a) are arranged beneath the first substrate holder surface (1s, 1s', 1so).

7. The device according to at least one of the preceding claims, wherein the first substrate holder surface (1, 1s', 1so) and the second substrate holder surface (1su) can be arranged at least partially, preferably completely, above one another, so that the first substrate (3, 3o) can drop on the second substrate (3u).

8. The device according to at least one of the preceding claims, wherein the at least three inner distance sensors (2i) and/or the at least three outer distance sensors (2a) can be moved in the radial direction relative to a reference point, in particular a centre-point, of the first substrate holder surface (1s, 1s', 1so).

9. The device according to at least one of the preceding claims, wherein the at least three inner distance sensors (2i) can be moved along the second circle (K2) and/or the at least three outer distance sensors (2a) can be moved along the first circle (K1).

10. The device according to at least one of the preceding claims, wherein the at least three inner distance sensors (2i) and/or the at least three outer distance sensors (2a) can be moved perpendicular to the first substrate holder surface (1s, 1s', 1so).

11. The device according to at least one of the preceding claims, wherein the first substrate holder (1, 1', 1o) and/or the second substrate holder (1u), in particular depending on the first distances and/or the second distances, can be aligned with one another, so that in particular a wedge error between the first substrate (3, 3o) and the second substrate (3u) can be compensated for.

12. The device according to at least one of the preceding claims, wherein the first substrate holder (1, 1', 1o) and/or the second substrate holder (1u) comprises regulatable fixing elements (9), so that the first substrate (3, 3o) and/or the second substrate (3u) can be fixed and/or released.

13. A method for the alignment of substrates, in particular wafers, in particular with a device according to at least one of the preceding claims, with the following steps, in particular with the following sequence:
i) mounting of a first substrate (3, 3o) on a first substrate holder surface (1s, 1s', 1so) of a first substrate holder (1, 1', 1o),
ii) mounting of a second substrate (3u) on a second substrate holder surface (1su) of a second substrate holder (1u), wherein the first substrate holder surface (1s, 1s', 1so) is facing the second substrate holder surface (1su),
iii) measurement of first distances between at least three inner distance sensors (2i) of the first substrate holder (1, 1', 1o) and the first substrate (3, 3o), in particular a first substrate surface (3so) of the first substrate (3, 3o),
iv) measurement of second distances between at least three outer distance sensors (2a) of the first substrate holder (1, 1', 1o) and of the second substrate holder surface (1su) of the second substrate holder (1u).

14. The method according to claim 13, wherein the method also comprises the following steps, in particular with the following sequence:
a) storage of the first distances of the at least three inner distance sensors (2i) measured in step iii) according to 13, in particular in an electronic data processing device,
b) transfer of the first substrate (3, 3o) to the second substrate holder (1u), so that the first substrate (3, 3o) lies on the second substrate (3u),
c) measurement of further first distances between the least three inner distance sensors (2i) and the first substrate (3, 3o), wherein the first substrate (3, 3o) lies on the second substrate (3u),
d) alignment of the first substrate holder (1, 1', 1o) and/or the second substrate holder (1u), so that in each case a difference between the respective further measured first distances of the at least three inner distance sensors (2i) and the respective stored first distances of the at least three inner distance sensors (2i) is the same, so that a wedge error between the first substrate (3, 3o) and the first substrate holder (1, 1', 1o) is compensated for,
e) storage of the second distances of the at least three outer distance sensors (2a) to the second substrate holder surface (1su) of the second substrate holder (1u) measured in step iv) according to claim 13, in particular in the electronic data processing device,
wherein the storage in step e) takes place after the alignment in step d).

15. The method according to at least one of the preceding claims, wherein the alignment of a further first substrate (3, 3o) and a further second substrate (3u) with one another takes place depending on the second distances, in particular takes place depending on the second distances stored in step e) according to claim 14, so that a wedge error between the further first substrate (3, 3o) and the further second substrate (3u) is compensated for.

## Revendications

1. Dispositif d'alignement de substrats, en particulier de tranches, présentant :
- un premier support de substrat (1, 1', 1o) pour recevoir un premier substrat (3,3o) sur une première surface de support de substrat (1s, 1s', 1so),
- un second support de substrat (1u) pour recevoir un second substrat (3u) sur une seconde surface de support de substrat (1 su),
- dans lequel la première surface de support de substrat (1s, 1s', 1so) est tournée vers la seconde surface de support de substrat (1su),
- dans lequel le premier support de substrat (1, 1', 1o) présente au moins trois capteurs de distance internes (2i) pour mesurer des premières distances par rapport au premier substrat (3, 3o), en particulier par rapport à une surface de substrat (3so) du premier substrat (3, 3o), et
- le premier support de substrat (1, 1', 1o) présente au moins trois capteurs de distance externes (2a) pour mesurer des secondes distances par rapport à la seconde surface de support de substrat (1su) du second support de substrat (1u).

2. Dispositif selon la revendication 1, dans lequel respectivement un des au moins trois capteurs de distance internes (2i) et respectivement un des au moins trois capteurs de distance externes (2a) forment ensemble une paire de capteurs de distance (5), dans lequel de préférence le capteur de distance interne (2i) respectif et le capteur de distance externe (2a) respectif de la paire de capteurs de distance (5) sont alignés dans la direction radiale, en partant d'un point de référence, en particulier d'un point médian, de la première surface de support de substrat (1s, 1s', 1so).

3. Dispositif selon l'une des revendications précédentes, dans lequel le premier support de substrat (1, 1', 1o) présente au moins trois paires de capteurs de distance (5), dans lequel le capteur de distance interne (2i) respectif et le capteur de distance externe (2a) respectif des au moins trois paires de capteurs de distance (5) sont alignés dans la direction radiale.

4. Dispositif selon au moins l'une ou plusieurs des revendications précédentes, dans lequel les au moins trois capteurs de distance externes (2a) sont disposés, en particulier décalés symétriquement, sur un premier cercle (K1) autour d'un point de référence, en particulier autour d'un point médian, de la première surface desupportdesubstrat(1s, 1s', 1so).

5. Dispositif selon au moins l'une ou plusieurs des revendications précédentes, dans lequel les au moins trois capteurs de distance internes (2i) sont disposés, en particulier décalés symétriquement, sur un second cercle (K2) autour d'un point de référence, en particulier autour d'un point médian, de la première surface de support de substrat (1s, 1s', 1so), dans lequel de préférence le premier cercle (K1) et le second cercle (K2) sont concentriques l'un par rapport à l'autre.

6. Dispositif selon au moins l'une ou plusieurs des revendications précédentes, dans lequel les au moins trois capteurs de distance internes (2i) et/ou les
au moins trois capteurs de distance externes (2a) sont disposés en dessous de la première surface de support de substrat (1s, 1s', 1so).

7. Dispositif selon au moins l'une des revendications précédentes, dans lequel la première surface de support de substrat (1s, 1s', 1so) etla seconde surface de support de substrat (1su) peuvent être disposées l'une sur l'autre, au moins partiellement, de préférence complètement, de façon à ce que le premier substrat (3, 3o) puisse être laissé tomber sur le second substrat (3u).

8. Dispositif selon au moins l'une des revendications précédentes, dans lequel les au moins trois capteurs de distance internes (2i) et/ou les au moins trois capteurs de distance externes (2a) sont mobiles dans le sens radial par rapport à un point de référence, en particulier un point médian, de la première surface de support de substrat (1s, 1s', 1so).

9. Dispositif selon au moins l'une des revendications précédentes, dans lequel les au moins trois capteurs de distance internes (2i) sont mobiles le long du second cercle (K2) et/ou les au moins trois capteurs de distance externes (2a) sont mobiles le long du premier cercle (K1).

10. Dispositif selon au moins l'une des revendications précédentes, dans lequel les au moins trois capteurs de distance internes (2i) et/ou les au moins trois capteurs de distance externes (2a) sont mobiles perpendiculairement à la première surface de support de substrat(1s, 1s', 1so).

11. Dispositif selon au moins l'une des revendications précédentes, dans lequel le premier support de substrat (1, 1', 1o) et/ou le second support de substrat (1u), en particulier en fonction des premières distances
et/ou des secondes distances, peuvent être alignés en eux, de sorte qu'en particulier une erreur de coin entre le premier substrat (3, 3o) et le second substrat (3u) est comparable.

12. Dispositif selon au moins l'une des revendications précédentes, dans lequel le premier support de substrat(1, 1', 1o) et/ou le second support de substrat (1u) présente(nt) des éléments de fixation réglables (9), de façon à ce que le premier substrat (3,3o) et/ou le second substrat (3u) puissent être fixés et/ou libérés.

13. Procédé d' alignement de substrats, en particulier de tranches, en particulier avec un dispositif selon au moins l'une des revendications précédentes, comprenant les étapes suivantes, en particulier avec le déroulement suivant :
i) réception d'un premier substrat (3, 3o) sur une première surface de support de substrat (1s, 1s', 1so) d'un premier support de substrat (1, 1', 1o),
ii) réception d'un second substrat (3u) sur une seconde surface de support de substrat (1su) d'un second support de substrat(1u), dans lequel la première surface de support de substrat(1s, 1s', 1so) est tournée vers la seconde surface de support de substrat (1su),
iii) mesure de premières distances entre au moins trois capteurs de distance internes (2i) du premier support de substrat(1, 1', 1o) etlepremiersubstrat(3, 3o), en particulier d'une surface de substrat(3so) du premier substrat (3,3o),
iv) mesure de secondes distances entre au moins trois capteurs de distance externes (2a) du premier support de substrat (1, 1', 1o) et la seconde surface de support de substrat (1su) du second support de substrat (1u).

14. Procédé selon la revendication 13, dans lequel le procédé comprend en plus les étapes suivantes, en particulier le déroulement suivant :
a) enregistrement des premières distances mesurées à l'étape iii) selon larevendication 13 des au moins trois capteurs de distance internes (2i), en particulier dans un dispositif de traitement de données électronique,
b) transfert du premier substrat (3, 3o) au second support de substrat (1u), de façon à ce que le premier substrat (3, 3o) repose sur le second substrat (3u),
c) mesure d'autres premières distances entre les au moins trois capteurs de distance internes (2i) et le premier substrat (3,3o), dans lequel le premier substrat (3,3o) repose sur le second substrat (3u),
d) alignement du premier support de substrat (1, 1', 1o) et/ou du second support de substrat (1u), de sorte que respectivement une différence entre les autres premières distances mesurées respectives des au moins trois capteurs de distance internes (2i) et les premières distances enregistrées respectives des au moins trois capteurs de distance internes (2i) soit égale, dans lequel une erreur de coin entre le premier substrat (3, 3o) et le premier support de substrat (1, 1', 1o) est compensée,
e) enregistrement des secondes distances mesurées à l'étape iv) selon la revendication 13 des au moins trois capteurs de distance externes (2a) par rapport à la seconde surface de support de substrat (1su) du second support de substrat (1u), en particulier dans le dispositif de traitement de données électronique,
dans lequel l'enregistrement à l'étape e) s'effectue après l'alignement à l'étape d).

15. Procédé selon au moins l'une des revendications précédentes, dans lequel l'alignement d'un autre premier substrat (3, 3o) et d'un autre second substrat (3u) entre eux est effectué en fonction des secondes distances, en particulier en fonction des secondes distances enregistrées à l'étape e) selon la revendication 14, de sorte qu'une une erreur de coin entre l'autre premier substrat (3, 3o) et l'autre second deuxième substrat (3u) est compensée.
